# EUROPÄISCHE PATENTSCHRIFT

(11) **EP 3 345 294 B1**
(45) Veröffentlichungstag und Bekanntmachung des Hinweises auf die Patenterteilung: **17.06.2020**
(21) Anmeldenummer: 16756701.5
(22) Anmeldetag: 24.08.2016
(51) Int. Cl.: H02M 7/487, G01R 19/165, H02M 1/36, H02M 1/32, G01R 31/50, G01R 31/66, G01R 31/42, G01R 29/16

(54) **VERFAHREN ZUM BETRIEB EINES WECHSELRICHTERS UND WECHSELRICHTER**
METHOD FOR OPERATING AN INVERTER AND INVERTER
PROCÉDÉ DE FONCTIONNEMENT D'UN ONDULEUR ET ONDULEUR

(30) Priorität: 31.08.2015 DE 102015114452
(43) Veröffentlichungstag der Anmeldung: 11.07.2018
(73) Patentinhaber: SMA Solar Technology AG, 34266 Niestetal (DE)
(72) Erfinder: CORREA VASQUES, Pablo Ignacio, 91080 Spardorf (DE); KNOBLOCH, Andreas, 34121 Kassel (DE)
(86) Internationale Anmeldenummer: PCT/EP2016/069992
(87) Internationale Veröffentlichungsnummer: WO 2017/036882

(56) Entgegenhaltungen:
- EP-A2- 2 608 375
- WO-A1-2015/074965
- EL-BARBARI S ET AL: "Digital control of a four leg inverter for standalone photovoltaic systems with unbalanced load", INDUSTRIAL ELECTRONICS SOCIETY, 2000. IECON 2000. 26TH ANNUAL CONFJERE NCE OF THE IEEE 22-28 OCT. 2000, PISCATAWAY, NJ, USA,IEEE, Bd. 1, 22. Oktober 2000 (2000-10-22), Seiten 729-734, XP010569707, ISBN: 978-0-7803-6456-1

## Beschreibung

### TECHNISCHES GEBIET DER ERFINDUNG

Die Erfindung betrifft ein Verfahren zum Betrieb eines Wechselrichters zur Umwandlung elektrischer Leistung einer Energieerzeugungseinheit und Einspeisung der umgewandelten elektrischen Leistung in ein Energieversorgungsnetz sowie einen Wechselrichter mit dem erfindungsgemäßen Verfahren.

### STAND DER TECHNIK

Wechselrichter können elektrische Leistung einer Energieerzeugungseinheit von Gleichstrom in Wechselstrom umwandeln und in ein Energieversorgungsnetz, beispielsweise ein Wechselspannungsnetz, einspeisen und/oder einem elektrischen Verbraucher zu dessen Betrieb direkt zuführen. Als Energieerzeugungseinheit können dabei insbesondere Generatoren verwendet werden, die elektrische Leistung aus regenerativen Quellen erzeugen, beispielsweise Photovoltaik- oder Windgeneratoren.

Ein Anschluss eines Wechselrichters an ein Wechselspannungsnetz kann auf verschiedene Arten erfolgen. Insbesondere bei Leistungen ab einigen Kilowatt können Wechselrichter verwendet werden, die über einen dreiphasigen Ausgang in ein dreiphasiges Wechselspannungsnetz einspeisen. Ein derartiges dreiphasiges Wechselspannungsnetz weist drei sogenannte Außenleiter oder Phasen auf, die regelmäßig als L1, L2 und L3 bezeichnet werden. Daneben kann ein Neutralleiter (kurz N-Leiter oder einfach N) und ggf. ein Schutzleiter (kurz PE-Leiter oder einfach PE) vorhanden sein, wobei N und PE auch als kombinierter PEN-Leiter ausgeführt sein können. Ein derartiges Vier-Leiter-Netz wird insbesondere als TN-System bezeichnet und kommt insbesondere im Niederspannungsbereich, z.B. in Verteilnetzen zum Einsatz.

Abweichend zu einem TN-System weist ein sogenanntes IT-System keinen Neutralleiter auf und stellt somit ein Drei-Leiter-Netz dar. Derartige IT-Systeme können insbesondere in Energieerzeugungsanlagen mit einer Vielzahl von Wechselrichtern verwendet werden, die über einen gemeinsamen Netzanschlusspunkt an ein übergeordnetes Verteil- oder Übertragungsnetz angeschlossen sind. Angesichts der Kosten für den Bau kann es für einen Betreiber einer ausgedehnten Energieerzeugungsanlage mit einer Vielzahl von Wechselrichtern und einer entsprechend großen Anzahl und Länge von Leitungen zwischen den Wechselrichtern und dem Netzanschlusspunkt vorteilhaft sein, ein 3-Leiter-Netz, beispielsweise ein IT-Netz, aufzubauen.

Der Betrieb eines Wechselrichters ist abhängig von der konkreten Ausführung des Wechselspannungsnetzes, an das der Wechselrichter angeschlossen ist. Beispielsweise wird eine für eine Regelung der Ausgangsströme des Wechselrichters notwendige Messung der Ausgangsspannungen zwischen den Außenleitern und einem Bezugspotential durchgeführt, wobei das Bezugspotential durch den Neutralleiter gebildet werden kann, wenn dieser vorhanden und an den Wechselrichter angeschlossen ist; andernfalls ist anderes Potential, beispielsweise ein Erdpotential als Bezugspotential zu wählen. Weiterhin können Schutzmaßnahmen wie eine Fehlerstromdetektion unterschiedlich ausgelegt werden, je nachdem, ob ein Stromfluss über einen Neutralleiter möglich ist oder nicht. Auch eine Parametrierung der Regelung der Ausgangsströme sowie die Erzeugung von Ausgangsströmen mit speziellen Eigenschaften, beispielsweise asymmetrischen Ausgangsströmen zur Stabilisierung des Wechselspannungsnetzes, hängen vom Vorhandensein eines Neutralleiters und dessen Anschluss an den Wechselrichter ab.

Es sind im Wesentlichen zwei unterschiedliche Arten der Betriebsführung eines Wechselrichters bekannt, die vom konkreten Aufbau der die Wechselrichter umfassenden Energieerzeugungsanlage abhängen, insbesondere von der konkreten Verkabelung innerhalb der Energieerzeugungsanlage bzw. vom konkreten Anschluss des Wechselrichters an das Wechselspannungsnetz. Ein Wechselrichter, der universell verwendet werden können soll, kann grundsätzlich einen Ausgangsanschluss umfassen, der auch zur Verbindung mit einem N-Leiter vorgesehen ist, wobei diese Verbindung nicht zwingend vorliegen muss und insbesondere dann nicht verwendet wird, wenn der Wechselrichter in ein 3-Leiter-Netz ohne Neutralleiter einspeisen soll.

Aus der EP 2251702 A1 ist eine Verdrahtungs-Prüfvorrichtung zum Prüfen einer Verdrahtung eines Wechselrichters bekannt, bei der der Wechselrichter zum Anschluss an ein Niederspannungsdrehstromnetz mit netzseitigen Leiterspannungen gegen einen Neutralleiter ausgeführt ist, wobei eine Messschaltung zur Messung der Leiterspannungen vorhanden ist. Aufgrund eines zusätzlichen Bauelementes, insbesondere eines Kondensators, das ausgangsseitig des Wechselrichters zwischen einer Phase und dem Neutralleiter geschaltet ist, entsteht bei fehlendem Neutralleiteranschluss eine Spannungsasymmetrie, die durch die Messung der Leiterspannungen feststellbar ist. Daraufhin kann eine Fehlermeldung bei fehlendem Neutralleiteranschluss ausgegeben werden. Das zusätzliche Bauteil erzeugt zusätzliche Kosten und verschlechtert die elektromagnetische Verträglichkeit des Wechselrichters, indem es die Eigenschaften eines ebenfalls ausgangsseitig des Wechselrichters angeordneten Ausgangsfilters negativ beeinflusst.

Aus der US 2009/0296289 A1 ist ein Verfahren zur Identifizierung eines Fehlers in einem Umrichter einer Motorsteuerung bekannt, wobei der Umrichter eingangsseitig an ein Wechselspannungsnetz angeschlossen ist und ausgangsseitig einen dreiphasigen Anschluss für einen Verbraucher ausweist. Ein eingangs- und/oder ausgangsseitig auftretender Erdschlussfehler kann detektiert werden, indem der Wechselrichter anhand seiner Ansteuerung versucht, ein Nullsystemstrom in das Wechselspannungsnetz einzuspeisen. Es wird ein Fehlersignal ausgegeben, wenn ein Nullsystemstrom in den an den Wechselrichter angeschlossenen Phasenleitern detektiert wird. Eine Verbindung des Umrichters mir einem etwaigen Neutralleiter des Wechselspannungsnetzes ist nicht offenbart.

Aus der WO 2015/074965 A1 ist ein Verfahren zum Betrieb eines Wechselrichters bekannt, bei dem der Wechselrichter über einen Anschluss für einen Nullleiter mit einem Nullleiter eines Wechselspannungsnetzes verbunden ist. Zwischen dem Anschluss für den Nullleiter und einem Mittelpunkt eines Gleichspannungszwischenkreises ist ein Schalter angeordnet, der in Abhängigkeit von verschiedenen Betriebsbedingungen des Wechselrichter geöffnet oder geschlossen werden kann, um den Mittelpunkt des Gleichspannungszwischenkreises mit dem Nullleiter des Wechselrichters zu trennen bzw. zu verbinden.

Aus der EP 2608375 A2 ist ein Wechselrichter bekannt, bei dem Phasenleiter und ein Neutralleiter über jeweils zwei Schaltkontakte mit dem Wechselrichter verbunden sind, sowie ein Verfahren zur Funktionsprüfung der den Phasenleitern zugeordneten Schaltkontakte ersichtlich.

Aus dem Artikel "Digital Control of a Four Leg Inverter for Standalone Photovoltaik Systems with Unbalanced Load" (EI-Barbari et al, 26TH Annual Conference of the Industrial Eloectronics Society, 2000, Bd. 1, S. 729-734) ist ein Verfahren zum Betrieb eines Wechselrichters bekannt, bei dem der Wechselrichter eine Last dreiphasige Last versorgt, deren Sternpunkt einen Neutralpunkt bildet, der mit dem Mittelpunkt eines Gleichspannungszwischenkreises des Wechselrichters verbunden ist.

### AUFGABE DER ERFINDUNG

Der Erfindung liegt die Aufgabe zugrunde, ein Verfahren zum Betrieb eines Wechselrichters zur Umwandlung elektrischer Leistung einer Energieerzeugungseinheit und Einspeisung der umgewandelten elektrischen Leistung in ein Energieversorgungsnetz bereitzustellen, wobei der Wechselrichter Ausgangsanschlüsse zum Anschluss von drei Phasen sowie eines Neutralleiters eines Wechselspannungsnetzes aufweist. Das Verfahren soll es ermöglichen, ohne zusätzliche Bauteile automatisch zu erkennen, ob der für die Verbindung mit dem Neutralleiter vorgesehene Anschluss tatsächlich mit einem Neutralleiter verbunden ist.

### LÖSUNG

Die Aufgabe wird durch ein Verfahren zum Betrieb eines Wechselrichters mit den Merkmalen des Patentanspruchs 1 sowie durch einen Wechselrichter mit den Merkmalen des Patentanspruchs 13 gelöst. Bevorzugte Ausführungsformen sind in den abhängigen Patentansprüchen definiert.

### BESCHREIBUNG DER ERFINDUNG

Ein Verfahren zum Betrieb eines Wechselrichters, der einen Anschluss mit vier Leiteranschlüssen zur Verbindung des Wechselrichters mit drei Außenleitern und einem Neutralleiter eines Wechselspannungsnetzes aufweist, umfasst einen Prüfschritt zur Bestimmung einer Anschlusskonfiguration des Wechselrichters mit dem Wechselspannungsnetz. Im Rahmen des Prüfschrittes werden Schaltelemente einer Brückenschaltung des Wechselrichters zur Erzeugung eines Nullsystems angesteuert. Ausgangsströme des Wechselrichters werden gemessen und hinsichtlich eines Nullsystemstromes ausgewertet. Wenn im Rahmen des Prüfschrittes ein Nullsystemstrom in den Ausgangsströmen detektiert wird, der einen vorgegebenen Schwellwert überschreitet, wird das Vorliegen einer Verbindung des Neutralleiters (N) mit einem zur Verbindung mit dem Neutralleiter (N) vorgesehenen Leiter anschluss (6) erkannt. Andernfalls, d.h. wenn kein oder ein zu geringer Nullsystemstrom im Rahmen des Prüfschrittes detektiert wird, wird erkannt, dass der Neutralleiter (N) nicht mit dem zur Verbindung mit dem Neutralleiter (N) vorgesehenen Leiteranschluss (6) verbunden ist.

Die Erfindung beruht auf der Erkenntnis, dass ein Nullsystemstrom nur dann gezielt eingespeist werden kann, wenn der Neutralleiter an den Wechselrichter angeschlossen ist, so dass ein geschlossener Stromkreis aus den Außenleitern und dem Neutralleiter über den Wechselrichter besteht. Zwar kann auch ohne angeschlossenen Neutralleiter ein asymmetrischer Strom in die Außenleiter eingespeist werden, der über etwaige Ableitkapazitäten zu einem Gleichspannungseingang gelangen und damit ebenfalls entlang eines geschlossenen Stromkreises fließen kann. Ein solcher Ableitstrom hat ähnliche Eigenschaften wie ein über einen Neutralleiter fließenden Nullsystemstrom, weist jedoch bei einer gegebenen Anregung eine deutlich niedrigere Amplitude auf, so dass ein über den Neutralleiter fließender Nullsystemstrom von einem Ableitstrom anhand des Vergleichs des detektierten Nullsystemstroms mit einem vorgegebenen Schwellwert unterschieden werden kann.

Das Ergebnis des Prüfschrittes wird für den weiteren Betrieb des Wechselrichters genutzt, um eine für die tatsächlich vorliegende Anschlusskonfiguration geeignete Betriebsführung des Wechselrichters auszuwählen. Wenn im Rahmen des Prüfschrittes erkannt wurdet, dass eine Verbindung des Neutralleiters mit dem zur Verbindung mit dem Neutralleiter vorgesehenen Leiteranschluss vorliegt und somit ein Neutralleiter an den Wechselrichter angeschlossen ist, wird für den weiteren Betrieb des Wechselrichters eine auf einen Vier-Leiter-Betrieb angepasste erste Betriebsführung ausgewählt; andernfalls wird eine auf einen Drei-Leiter-Betrieb angepasste zweite Betriebsführung ausgewählt. Durch diese automatische Auswahl der auf die jeweilige tatsächliche Anschlusskonfiguration angepassten Betriebsführung ist es möglich, einen Wechselrichter einerseits universell einsetzbar zu gestalten, indem er sowohl an einem Drei-Leiter-Netz als auch an einem Vier-Leiter-Netz optimal betrieben werden kann. Andererseits sind mögliche Fehlfunktionen ausgeschlossen, indem die tatsächliche Anschlusskonfiguration zuverlässig erkannt und die Betriebsführung des Wechselrichters darauf adaptiert wird, so dass keine Funktionen im Rahmen der Betriebsführung ausgeführt werden, die nicht für die tatsächliche Anschlusskonfiguration geeignet sind. So kann beispielsweise eine Erfassung von elektrischen Messwerten am Ausgang des Wechselrichters von der tatsächlichen Anschlusskonfiguration beeinflusst sein, und bestimmte Funktionen im Rahmen der Betriebsführung, beispielsweise eine asymmetrische Einspeisung in die Außenleiter des Wechselspannungsnetzes, sind nur ausführbar, wenn der Neutralleiter an den Wechselrichter angeschlossen ist.

Grundsätzlich kann ein Wechselrichter von einem Betreiber für die Installation in einer konkreten PV-Anlage mit einer konkreten Anschlusskonfiguration vorgesehen sein. Dazu kann anhand eines im Wechselrichter gespeicherten Vorgabewertes vorgegeben sein, ob der Wechselrichter in einem Einspeisebetrieb anhand der ersten Betriebsführung oder der zweiten Betriebsführung betrieben werden soll. Bei einem Widerspruch zwischen der durch den Vorgabewert vorgegebenen Betriebsführung und der aufgrund des Prüfschrittes zu wählenden Betriebsführung kann eine Warnmeldung erzeugt werden, die im Wechselrichter gespeichert und/oder an einen Betreiber des Wechselrichters kommuniziert werden kann.

Der Wechselrichter kann im Folgenden anhand der aufgrund des Prüfschrittes gewählten Betriebsführung betrieben werden. Dabei kann vorgesehen sein, dass der Wechselrichter bei einem Widerspruch zwischen der durch den Vorgabewert vorgegebenen Betriebsführung und der aufgrund des Prüfschrittes gewählten Betriebsführung keine elektrische Energie in das Wechselspannungsnetz einspeist. Dadurch kann automatisch vermieden werden, dass der Wechselrichter bei Vorliegen einer tatsächlichen Anschlusskonfiguration, die von derjenigen abweicht, für die der Wechselrichter vorgesehen ist, in einen Einspeisebetrieb übergeht und ggf. von einem Betreiber der PV-Anlage nicht gewünschte Funktionen ausführt. Eine Prüfung auf einen solchen Widerspruch kann vor einer Aktivierung der Betriebsführung, insbesondere im Anschluss an den Prüfschritt, oder als einer der ersten Schritte im Rahmen der Betriebsführung nach deren Aktivierung erfolgen, insbesondere bevor der Wechselrichter elektrische Leistung in das Wechselspannungsnetz einspeist.

In einer Ausführungsform des Verfahrens kann vorgesehen sein, dass der Wechselrichter elektrische Leistung in das Wechselspannungsnetz einspeist, wobei die erste Betriebsführung insbesondere eine asymmetrische Einspeisung der Ausgangsströme in das Wechselspannungsnetz umfassen kann. Die Einspeisung elektrischer Leistung kann grundsätzlich unabhängig von einem etwaigen Widerspruch zwischen der durch den Vorgabewert vorgegebenen Betriebsführung und der aufgrund des Prüfschritts gewählten Betriebsführung geschehen, indem das Verfahren sicherstellt, dass die Auswahl einer Betriebsführung aufgrund des Prüfschritts einer zuverlässigen Detektion der tatsächlich vorliegenden Anschlusskonfiguration entspricht und somit der Wechselrichter anhand der aufgrund des Prüfschritts gewählten Betriebsführung zumindest zeitweise zuverlässig mit der tatsächlichen vorliegenden Anschlusskonfiguration betrieben werden kann. Es genügt, im Falle eines Widerspruchs die oben angesprochene Warnmeldung zu erzeugen und gegebenenfalls an den Betreiber des Wechselrichters zu kommunizieren.

Der Prüfschritt kann im Rahmen einer Inbetriebnahme des Wechselrichters ausgeführt werden. Dadurch kann sichergestellt werden, dass die vor Inbetriebnahme des Wechselrichters hergestellte Anschlusskonfiguration bei der Betriebsführung des Wechselrichters berücksichtigt wird und etwaige Widersprüche zu vorgegebenen Betriebsführungen aufgedeckt und verarbeitet werden.

In einer Ausführungsform des Verfahrens können die Schaltelemente der Brückenschaltung des Wechselrichters im Rahmen des Prüfschrittes zur Erzeugung eines Nullsystems mit einer Frequenz oberhalb einer Netzfrequenz angesteuert werden. Insbesondere kann die Frequenz des Nullsystems ein nicht-ganzzahliges Vielfaches der Netzfrequenz aufweisen. Dadurch wird gewährleistet, dass das Verfahren unabhängig von etwaigen Einflüssen der Eigenschaften des angeschlossenen Wechselspannungsnetzes arbeitet, insbesondere indem netzfrequente Anteile an Ableitströmen oder dem vom Wechselrichter erzeugten Nullsystem entgegen gerichtete Nullsystemströme aus dem Wechselspannungsnetz sowie deren jeweilige Oberschwingungen nicht bei der Auswertung der zum Prüfschritt gehörenden Nullsystemströme berücksichtigt werden.

In einer weiteren Ausführungsform des Verfahrens kann zur Ansteuerung der Schaltelemente der Brückenschaltung des Wechselrichters im Rahmen des Prüfschrittes eine Regelungsstruktur verwendet werden, in der ein Sollwert für den Nullsystemstrom mit einem Istwert des Nullsystemstromes verglichen wird. Durch Verwendung einer solchen Regelungsstruktur kann das Verfahren besonders robust implementiert werden, indem der Wechselrichter anstrebt, einen Nullsystemstrom einzuspeisen, der oberhalb des Schwellwertes liegt, und dazu notwendige Stellgrößen, insbesondere Ausgangsspannungen des Wechselrichters, sukzessive erhöht. Alternativ oder zusätzlich zum Erreichen des Schwellwertes stellt dann eine Abweichung zwischen dem Sollwert des Nullsystemstromes und dem mit sinnvollen Stellgrößen erreichbarem Istwert ein geeignetes Kriterium zur Erkennung auf das Vorhandensein eines Neutralleiters dar, indem eine kleine Abweichung auf eine erfolgreiche Anregung und damit den angeschlossenen Neutralleiter hinweist, während eine große Abweichung bedeutet, dass der Sollwert nicht erreichbar ist und kein Nullsystemstrom erzeugt werden kann, da kein Neutralleiter an den Wechselrichter angeschlossen ist.

Ein Wechselrichter zur Umwandlung elektrischer Leistung von Gleichstrom in Wechselstrom und Einspeisung der umgewandelten elektrischen Leistung in ein Wechselspannungsnetz weist einen Anschluss mit vier Leiteranschlüssen zur Verbindung des Wechselrichters mit drei Außenleitern und einem Neutralleiter eines Wechselspannungsnetzes auf. Ein erfindungsgemäßer Wechselrichter umfasst eine Steuerungseinheit, die dazu eingerichtet ist, den Wechselrichter mit einem in den vorangehenden Abschnitten dieser Beschreibung dargestellten Verfahren zu betreiben.

Der für den Anschluss des Neutralleiters vorgesehene Leiteranschluss kann dabei mit einem Mittelpunkt eines gleichstromseitigen Spannungszwischenkreises verbunden sein. Alternativ kann der für den Anschluss des Neutralleiters vorgesehene Leiteranschluss mit einer Verbindung zwischen zwei Halbleiterschaltelementen verbunden sein, wobei diese Halbleiterschaltelemente eine parallel zu einem gleichstromseitigen Spannungszwischenkreises angeordnete Reihenschaltung ausbilden. In diesen Fällen kann zwischen dem für den Anschluss des Neutralleiters vorgesehenen Leiteranschluss und dem Mittelpunkt eines gleichstromseitigen Spannungszwischenkreises bzw. der Verbindung zwischen den Halbleiterschaltelementen der parallel zu dem gleichstromseitigen Spannungszwischenkreises angeordneten Reihenschaltung ein weiteres Schaltelement vorgesehen sein.

### KURZBESCHREIBUNG DER FIGUREN

Im Folgenden wird die Erfindung anhand in den Figuren dargestellter Ausführungsbeispiele weiter erläutert und beschrieben.
- Fig. 1: zeigt schematisch einen Wechselrichter, der über ein Vier-Leiter-System mit einem Wechselspannungsnetz verbunden ist, und
- Fig. 2: zeigt ein Blockdiagramm eines erfindungsgemäßen Verfahrens zum Betrieb eines Wechselrichters.

### FIGURENBESCHREIBUNG

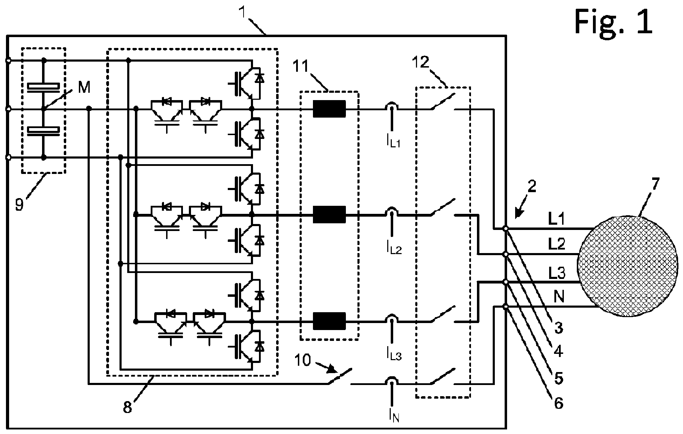

**Fig. 1** zeigt einen Wechselrichter 1, der einen Anschluss 2 mit vier Leiteranschlüssen 3-6 aufweist. An die Leiteranschlüsse 3, 4 und 5 sind drei Außenleiter L1, L2 und L3 eines Wechselspannungsnetzes 7 angeschlossen. An den Leiteranschluss 6 ist gemäß Fig. 1 ein Neutralleiter N des Wechselspannungsnetzes 7 angeschlossen, wobei der Anschluss des Neutralleiters N an den Leiteranschluss 6 grundsätzlich optional ist und insbesondere dann entfällt, wenn das Wechselspannungsnetz 7 oder die Anschlussanlagen innerhalb einer ausgedehnten PV-Anlage, die den Wechselrichter 1 umfasst, gar keinen Neutralleiter aufweisen.

Der Wechselrichter 1 weist eine Brückenschaltung 8 auf, die eine Anzahl in mehreren Brückenzweigen angeordneter Schaltelemente aufweist. Die Brückenschaltung 8 kann verschiedene Topologien aufweisen und beispielsweise als B6-Brücke, als NPC-Brücke (Neutral Point Clamped) oder als die in Fig. 1 dargestellte sogenannte BS-NPC-Brücke (Bidirectional Switch NPC) realisiert werden, wobei als Schaltelemente der Brückenschaltung in der Regel Halbleiterschalter, beispielsweise MOSFETs oder IGBTs verwendet werden. Eingangsseitig weist der Wechselrichter 1 einen Gleichspannungszwischenkreis 9 auf, der in der Ausführungsform gemäß Fig. 1 aus einer Reihenschaltung zweier Kapazitäten besteht und einen Mittelpunkt M aufweist. Der Mittelpunkt M ist über einen weiteren Schalter 10, beispielsweise ein Relais, mit dem Leiteranschluss 6 verbunden. In einer alternativen Ausführungsform als sogenannter "three-phase four-leg inverter" kann ein weiterer parallel zu dem Gleichspannungszwischenkreis 9 angeordneter Brückenzweig mit einer Reihenschaltung zweier Halbleiterschaltelemente vorgesehen sein, wobei der Leiteranschluss 6 mit einer Verbindung zwischen den Halbleiterschaltelementen dieser Reihenschaltung verbunden sein kann. Der Gleichspannungszwischenkreis 9 kann dann einteilig ausgebildet sein, wenn für die mit den Leiteranschlüssen 3, 4 und 5 verbundenen Brückenzweige ebenfalls keine Verbindung mit einem Mittelpunkt M vorgesehen ist, wie dies beispielsweise bei einer B6-Brücke der Fall ist.

Ausgangsseitig weist der Wechselrichter 1 einen Filter 11 zur Glättung von Ausgangsströmen I_{L1}, I_{L2}, I_{L3} auf, wobei die Ausgangsströme I_{L1}, I_{L2}, I_{L3} mittels der von den Halbleiterschaltern getakteten Ausgangsspannung der Brückenschaltung 8 erzeugt werden. Die Ausgangsströme I_{L1}, I_{L2}, I_{L3} werden mittels Stromsensoren gemessen und als Istwerte in eine Regelung des Wechselrichters eingegeben. Mittels einer schaltbaren Netztrennstelle 12 kann die Brückenschaltung 8 bzw. der Gleichspannungszwischenkreis 9 mit den Leiteranschlüssen 3-6 verbunden werden, um eine Einspeisung der Ausgangsströme I_{L1}, I_{L2}, I_{L3} in das Wechselspannungsnetz 7 zu ermöglichen und bei Bedarf, insbesondere in einem Fehlerfall, die Elektronik des Wechselrichters 1 wieder vom Wechselspannungsnetz 7 zu trennen.

Im Folgenden wird erläutert, wie der Wechselrichter 1 gemäß Fig. 1 derart betrieben werden kann, dass das Vorhandensein eines Neutralleiters und dessen Anschluss an den Wechselrichter automatisch detektiert werden kann.

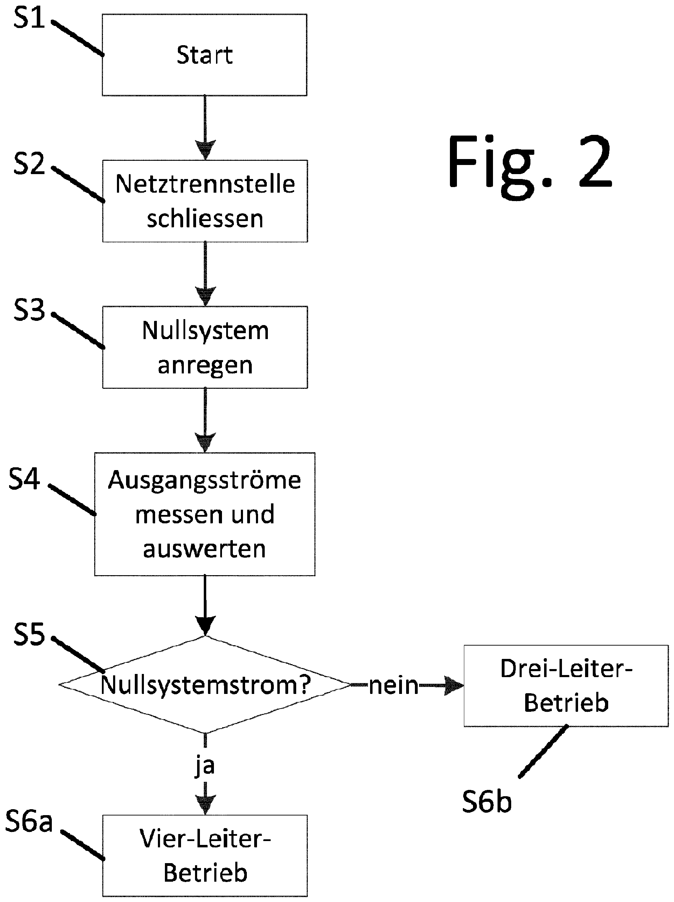

Fig. 2 zeigt in Form eines Blockdiagramms eine Ausführungsform des erfindungsgemäßen Verfahrens. In Schritt S1 wird der Wechselrichter 1 gestartet, beispielsweise erstmals im Rahmen einer Inbetriebnahme einer den Wechselrichter 1 umfassenden PV-Anlage oder morgens bei ausreichender Sonneneinstrahlung auf einen an den Wechselrichter 1 angeschlossenen Photovoltaik-Generator. In Schritt S2 wird die Netztrennstelle 12 geschlossen, d.h. es wird eine Verbindung von der Brückenschaltung 8 über die Leiteranschlüsse 3, 4 und 5 zu den Außenleitern L1, L2, L3 sowie vom Mittelpunkt M des Gleichspannungszwischenkreises 9 über den Leiteranschluss 6 zu einem gegebenenfalls vorhandenen Neutralleiter N hergestellt.

In Schritt S3 werden die Schaltelemente der Brückenschaltung 8 des Wechselrichters 1 derart angesteuert, dass ein Nullsystem am Anschluss 2 des Wechselrichters 1 angeregt wird. Dazu können beispielsweise die Schaltelemente eines Brückenzweiges einzeln oder mehrere Brückenzweige phasengleich angesteuert werden, so dass ein Ausgangsstrom angestrebt wird, der einen Nullsystemstrom umfasst oder sogar ausschließlich aus einem Nullsystemstrom besteht. Alternativ oder zusätzlich können beispielsweise in einer Regelung des Wechselrichters 1 Sollwerte für einen Nullsystemstrom vorgegeben werden, die mit einem aus den gemessenen Ausgangsströme I_{L1}, I_{L2}, I_{L3} ermittelten Istwert eines tatsächlich angeregten Nullsystemstroms verglichen werden. Dabei können die Istwerte des Nullsystemstroms mittels einer geeigneten Transformation aus den gemessenen Ausgangsströmen I_{L1}, I_{L2}, I_{L3} abgeleitet werden, insbesondere mittels einer Transformation aus dem Zeitbereich in ein Koordinatensystem mit sogenannten dq0-Komponenten (Park-Transformation) oder alpha-beta-null-Komponenten (Clarke-Transformation). Im Rahmen der Regelung kann dann mittels einer Regelschleife angestrebt werden, die Istwerte durch geeignete Ansteuerung der Schaltelemente der Brückenschaltung 8 an die Sollwerte anzunähern.

In Schritt S4 werden die gemessenen Ausgangsströme I_{L1}, I_{L2}, I_{L3} gezielt hinsichtlich der Nullsystemströme ausgewertet. Dies kann auf Basis der im Rahmen von Schritt S3 durchgeführten Transformation der Ausgangsströme I_{L1}, I_{L2}, I_{L3} in das symmetrische Koordinatensystem oder auch separat mittels einer weiteren geeigneten Auswertung erfolgen.

Das Ergebnis von Schritt S4 repräsentiert eine Amplitude eines durch die Anregung in Schritt S3 erzeugten Nullsystemstroms. In Schritt S5 wird dieses Ergebnis dahingehend bewertet, ob ein Nullsystemstrom erfolgreich angeregt wurde oder nicht. Diese Bewertung kann beispielsweise einen Vergleich der Amplitude des angeregten Nullsystemstromes mit einem Schwellwert umfassen. Alternativ können die in der Regelung verwendeten Soll- und Istwerte des Nullsystemstroms verglichen werden, wobei eine geringe Regelabweichung zwischen Soll- und Istwert des Nullsystemstroms auf eine erfolgreiche Anregung eines Nullsystemstromes hinweist.

Sofern in Schritt S6 festgestellt wird, dass ein Nullsystemstrom erfolgreich angeregt werden kann, wird erkannt, dass ein Neutralleiter N über den Leiteranschluss 6 an den Wechselrichter 1 angeschlossen ist. In diesem Fall wird der Wechselrichter 1 gemäß Schritt S6a in einem Vier-Leiter-Betrieb betrieben.

Sofern in Schritt S6 festgestellt wird, dass Nullsystemstrom nicht angeregt werden kann, wird erkannt, dass der Neutralleiter N nicht über den Leiteranschluss 6 an den Wechselrichter 1 angeschlossen ist bzw. dass kein Neutralleiter N in Anschlussanlagen des Wechselrichters 1 oder in dem Wechselspannungsnetz 7 vorhanden ist. In diesem Fall wird der Wechselrichter 1 gemäß Schritt S6b in einem Drei-Leiter-Betrieb betrieben.

Grundsätzlich kann der Wechselrichter 1 eine Verbindung zwischen dem Mittelpunkt M und dem Neutralleiter N, sofern dieser vorhanden ist, mittels des Schalters 10 auch selbst herstellen bzw. trennen und somit von einem Drei- in einen Vier-Leiter-Betrieb wechseln bzw. umgekehrt. Dasselbe gilt für die oben beschriebene Verbindung zwischen dem etwaig vorhandenen Neutralleiter N und der parallel zu dem Gleichspannungszwischenkreis 9 angeordnete Reihenschaltung des weiteren Brückenzweiges eines "three-phase four-leg inverters". Ein solcher Wechsel der Betriebsart kann insbesondere dann sinnvoll sein, wenn der Wechselrichter 1 trotz vorhandenem und angeschlossenem Neutralleiter N so lange wie möglich in einem Drei-Leiter-Betrieb arbeiten soll, z.B. aus Effizienzgründen, und nur dann mittels Aktiverung des Schalters 10 im Vier-Leiter-Betrieb arbeiten soll, wenn es notwendig ist, also beispielsweise wenn asymmetrische Ausgangsströme I_{L1}, I_{L2}, I_{L3} zur Netzstützung erzeugt werden sollen.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Elemente können durch weitere Merkmale ergänzt werden oder die einzigen Elemente sein, auf die sich das jeweilige Verfahren oder die jeweilige Vorrichtung bezieht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### Bezugszeichenliste

- 1: Wechselrichter
- 2: Anschluss
- 3-6: Leiteranschlüsse
- 7: Wechselspannungsnetz
- 8: Brückenschaltung
- 9: Gleichspannungszwischenkreis
- 10: Schaltelement
- 11: Filter
- 12: Netztrennstelle
- L1, L2, L3: Außenleiter
- I_{L1}, I_{L2}, I_{L3}: Ausgangsströme
- M: Mittelpunkt
- S1-S5, S6a, S6b: Verfahrensschritte

## Patentansprüche

1. Verfahren zum Betrieb eines Wechselrichters (1), der einen Anschluss (2) mit vier Leiteranschlüssen (3-6) zur Verbindung des Wechselrichters (1) mit drei Außenleitern (L1,L2,L3) und einem Neutralleiter (N) eines Wechselspannungsnetzes (7) aufweist,
wobei das Verfahren einen Prüfschritt zur Bestimmung einer Anschlusskonfiguration des Wechselrichters (1) mit dem Wechselspannungsnetz (7) umfasst,
wobei Schaltelemente einer Brückenschaltung (8) des Wechselrichters (1) im Rahmen des Prüfschrittes zur Erzeugung eines Nullsystems angesteuert werden,
**dadurch gekennzeichnet, dass**
im Rahmen des Prüfschrittes Ausgangsströme (I_{L1},I_{L2},I_{L3},I_{N}) des Wechselrichters (1) gemessen und hinsichtlich eines Nullsystemstromes ausgewertet werden und das Vorliegen einer Verbindung des Neutralleiters (N) mit einem zur Verbindung mit dem Neutralleiter (N) vorgesehenen Leiteranschluss (6) erkannt wird, wenn im Rahmen des Prüfschrittes ein Nullsystemstrom detektiert wird, der einen vorgegebenen Schwellwert überschreitet, so dass der über den Neutralleiter fließende Nullsystemstrom von einem Ableitstrom anhand des Vergleichs des detektierten Nullsystemstroms mit dem vorgegebenen Schwellwert unterschieden werden kann, wobei andernfalls erkannt wird, dass der Neutralleiter (N) nicht mit dem zur Verbindung mit dem Neutralleiter (N) vorgesehenen Leiteranschluss (6) verbunden ist.

2. Verfahren nach Anspruch 1, **dadurch gekennzeichnet, dass** für den weiteren Betrieb des Wechselrichters (1) eine auf einen Vier-Leiter-Betrieb mit angeschlossenem Neutralleiter (N) angepasste erste Betriebsführung ausgewählt wird, wenn im Rahmen des Prüfschrittes erkannt wurde, dass eine Verbindung des Neutralleiters (N) mit dem zur Verbindung mit dem Neutralleiter (N) vorgesehenen Leiteranschluss (6) vorliegt, und dass andernfalls eine auf einen Drei-Leiter-Betrieb ohne angeschlossenen Neutralleiter (N) angepasste zweite, von der ersten Betriebsführung unterschiedliche Betriebsführung ausgewählt wird

3. Verfahren nach Anspruch 2, **dadurch gekennzeichnet, dass** anhand eines im Wechselrichter (1) gespeicherten Vorgabewertes vorgegeben ist, ob der Wechselrichter (1) in einem Einspeisebetrieb anhand der ersten Betriebsführung oder anhand der zweiten Betriebsführung betrieben werden soll.

4. Verfahren nach Anspruch 3, **dadurch gekennzeichnet, dass** bei einem Widerspruch zwischen der durch den Vorgabewert vorgegebenen Betriebsführung und der aufgrund des Prüfschrittes zu wählenden Betriebsführung eine Warnmeldung erzeugt wird, die im Wechselrichter (1) gespeichert und/oder an einen Betreiber des Wechselrichters (1) kommuniziert wird.

5. Verfahren nach einem der Ansprüche 2 bis 4, **dadurch gekennzeichnet, dass** der Wechselrichter (1) anhand der aufgrund des Prüfschrittes gewählten Betriebsführung betrieben wird.

6. Verfahren nach einem der Ansprüche 3 bis 5, **dadurch gekennzeichnet, dass** der Wechselrichter (1) bei einem Widerspruch zwischen der durch den Vorgabewert vorgegebenen Betriebsführung und der aufgrund des Prüfschritts gewählten Betriebsführung keine elektrische Leistung in das Wechselspannungsnetz (7) einspeist.

7. Verfahren nach Anspruch 5, **dadurch gekennzeichnet, dass** der Wechselrichter (1) elektrische Leistung in das Wechselspannungsnetz (8) einspeist.

8. Verfahren nach Anspruch 7, **dadurch gekennzeichnet, dass** die erste Betriebsführung eine asymmetrische Einspeisung der Ausgangsströme (I_{L1},I_{L2},I_{L3}) in das Wechselspannungsnetz (7) umfasst.

9. Verfahren nach einem der vorangehenden Ansprüche, **dadurch gekennzeichnet, dass** der Prüfschritt im Rahmen einer Inbetriebnahme und/oder während eines Aufstartvorgangs des Wechselrichters (1) ausgeführt wird.

10. Verfahren nach einem der vorangehenden Ansprüche, **dadurch gekennzeichnet, dass** die Schaltelemente der Brückenschaltung (8) des Wechselrichters (1) im Rahmen des Prüfschrittes zur Erzeugung eines Nullsystems mit einer Frequenz oberhalb einer Netzfrequenz angesteuert werden.

11. Verfahren nach Anspruch 10, **dadurch gekennzeichnet, dass** die Frequenz des Nullsystems ein nicht-ganzzahliges Vielfaches der Netzfrequenz aufweist.

12. Verfahren nach einem der vorangehenden Ansprüche, **dadurch gekennzeichnet, dass** zur Ansteuerung der Schaltelemente der Brückenschaltung (8) des Wechselrichters (1) im Rahmen des Prüfschrittes eine Regelungsstruktur verwendet wird, in der ein Sollwert für den Nullsystemstrom mit einem Istwert des Nullsystemstromes verglichen wird.

13. Wechselrichter (1) zur Umwandlung elektrischer Leistung von Gleichstrom in Wechselstrom und Einspeisung der umgewandelten elektrischen Leistung in ein Wechselspannungsnetz (8), wobei der Wechselrichter (1) einen Anschluss (2) mit vier Leiteranschlüssen (3-6) zur Verbindung des Wechselrichters (1) mit drei Außenleitern (L1,L2,L3) und einem Neutralleiter (N) eines Wechselspannungsnetzes (7) aufweist, **dadurch gekennzeichnet, dass** der Wechselrichter (1) eine Steuerungseinheit umfasst, die dazu eingerichtet ist, den Wechselrichter (1) mit einem Verfahren nach einem der vorangehenden Ansprüche zu betreiben.

14. Wechselrichter (1) nach Anspruch 13, **dadurch gekennzeichnet, dass** der für den Anschluss des Neutralleiters (N) vorgesehene Leiteranschluss (6) mit einem Mittelpunkt (M) eines Gleichspannungszwischenkreises (9) verbunden ist.

15. Wechselrichter (1) nach einem der Ansprüche 13 oder 14, **dadurch gekennzeichnet, dass** der für den Anschluss des Neutralleiters (N) vorgesehene Leiteranschluss (6) mit einer Verbindung zwischen zwei Halbleiterschaltelementen verbunden ist, wobei die Halbleiterschaltelemente eine parallel zu einem Gleichspannungszwischenkreis (9) angeordnete Reihenschaltung ausbilden.

16. Wechselrichter (1) nach einem der Ansprüche 14 oder 15, **dadurch gekennzeichnet, dass** der für den Anschluss des Neutralleiters (N) vorgesehene Leiteranschluss (6) über ein Schaltelement (10) mit dem Mittelpunkt (M) des gleichstromseitigen Gleichspannungszwischenkreises (9) bzw. mit der Verbindung zwischen den Halbleiterschaltelementen der parallel zu dem Gleichspannungszwischenkreis (9) angeordneten Reihenschaltung verbunden ist.

## Claims

1. A method for operating an inverter (1), which has a terminal (2) with four conductor connectors (3-6) for connection of the inverter (1) to three outer conductors (L1, L2, L3) and to a neutral conductor (N) of an AC voltage grid (7),
wherein the method comprises a checking step for determining a connection configuration of the inverter (1) to the AC voltage grid (7),
wherein switching elements of a bridge circuit (8) of the inverter (1) are actuated, as part of the checking step, to generate a zero-phase sequence system,
**characterized in that,**
as part of the checking step, output currents (I_{L1},I_{L2},I_{L3},I_{N}) of the inverter (1) are measured and evaluated with respect to a zero-phase sequence system current, and the presence of a connection of the neutral conductor (N) to a conductor connector (6) provided for connection to the neutral conductor (N) is identified when, as part of the checking step, a zero-phase sequence system current that exceeds a prescribed threshold value is detected, such that the zero-phase sequence system current that flows via the neutral conductor may be distinguished from a discharge current on the basis of the comparison of the detected zero-phase sequence system current with the prescribed threshold value, wherein, if this is not the case, it is identified that the neutral conductor (N) is not connected to the conductor connector (6) provided for connection to the neutral conductor (N).

2. The method as claimed in claim 1, **characterized in that,** for the further operation of the inverter (1), a first operational management procedure adjusted to four-conductor operation with connected neutral conductor (N) is selected when, as part of the checking step, it has been identified that there is a connection of the neutral conductor (N) to the conductor connector (6) provided for connection to the neutral conductor (N), and **in that**, if this is not the case, a second operational management procedure adjusted to three-conductor operation without connected neutral conductor (N) is selected, said second operational management procedure being different from the first operational management procedure.

3. The method as claimed in claim 2, **characterized in that** a preset value stored in the inverter (1) is used to prescribe whether the inverter (1) is to be operated in a feed-in mode on the basis of the first operational management procedure or on the basis of the second operational management procedure.

4. The method as claimed in claim 3, **characterized in that,** in the event of a discrepancy between the operational management procedure prescribed by the preset value and the operational management procedure to be selected on account of the checking step, a warning message is generated, said warning message being stored in the inverter (1) and/or being communicated to an operator of the inverter (1).

5. The method as claimed in one of claims 2 to 4, **characterized in that** the inverter (1) is operated on the basis of the operational management procedure selected on account of the checking step.

6. The method as claimed in one of claims 3 to 5, **characterized in that**, in the event of a discrepancy between the operational management procedure prescribed by the preset value and the operational management procedure selected on account of the checking step, the inverter (1) does not feed electrical power into the AC voltage grid (7).

7. The method as claimed in claim 5, **characterized in that** the inverter (1) feeds electrical power into the AC voltage grid (8).

8. The method as claimed in claim 7, **characterized in that** the first operational management procedure comprises asymmetrical in-feeding of the output currents (I_{L1},I_{L2},I_{L3}) to the AC voltage grid (7).

9. The method as claimed in one of the preceding claims, **characterized in that** the checking step is executed as part of an activation and/or during a start-up process of the inverter (1).

10. The method as claimed in one of the preceding claims, **characterized in that**, as part of the checking step, the switching elements of the bridge circuit (8) of the inverter (1) are actuated to generate a zero-phase sequence system at a frequency above a grid frequency.

11. The method as claimed in claim 10, **characterized in that** the frequency of the zero-phase sequence system has a non-integer multiple of the grid frequency.

12. The method as claimed in one of the preceding claims, **characterized in that**, as part of the checking step, a control structure is used to actuate the switching elements of the bridge circuit (8) of the inverter (1), in which control structure a setpoint value for the zero-phase sequence system current is compared with an actual value of the zero-phase sequence system current.

13. An inverter (1) for converting electrical power from direct current to alternating current and in-feeding the converted electrical power to an AC voltage grid (8), wherein the inverter (1) has a terminal (2) with four conductor connectors (3-6) for connection of the inverter (1) to three outer conductors (L1, L2, L3) and to a neutral conductor (N) of an AC voltage grid (7), **characterized in that** the inverter (1) comprises a control unit, which is configured to operate the inverter (1) using a method as claimed in one of the preceding claims.

14. The inverter (1) as claimed in claim 13, **characterized in that** the conductor connector (6) provided for the connection of the neutral conductor (N) is connected to a center point (M) of a DC link circuit (9).

15. The inverter (1) as claimed in either of claims 13 and 14, **characterized in that** the conductor connector (6) provided for the connection of the neutral conductor (N) is connected to a connection between two semiconductor switching elements, wherein the semiconductor switching elements form a series circuit arranged in parallel with a DC link circuit (9).

16. The inverter (1) as claimed in either of claims 14 and 15, **characterized in that** the conductor connector (6) provided for the connection of the neutral conductor (N) is connected by means of a switching element (10) to the center point (M) of the DC-side DC link circuit (9) or to the connection between the semiconductor switching elements of the series circuit arranged in parallel with the DC link circuit (9).

## Revendications

1. Procédé pour faire fonctionner un onduleur (1), lequel possède un raccordement (2) comprenant quatre bornes de conducteur (3-6) destinées à relier l'onduleur (1) à trois conducteurs externes (L1, L2, L3) et un conducteur neutre (N) d'un réseau de tension alternative (7),
le procédé comprenant une étape de contrôle destinée à déterminer une configuration de raccordement de l'onduleur (1) au réseau de tension alternative (7),
des éléments de commutation d'un circuit en pont (8) de l'onduleur (1) étant commandés dans le cadre de l'étape de contrôle en vue de générer un système homopolaire
**caractérisé en ce que**
dans le cadre de l'étape de contrôle, les courants de sortie (I_{L1}, I_{L2}, I_{L3}, I_{N}) de l'onduleur (1) sont mesurés et interprétés du point de vue d'un courant de système homopolaire et la présence d'une liaison du conducteur neutre (N) avec une borne de conducteur (6) destinée à la liaison avec le conducteur neutre (N) est reconnue lorsque, dans le cadre de l'étape de contrôle, un courant de système homopolaire qui dépasse une valeur de seuil prédéfinie est détecté, de sorte que le courant de système homopolaire qui circule sur le conducteur neutre peut être différencié d'un courant de fuite à l'aide de la comparaison du courant de système homopolaire avec la valeur de seuil prédéfinie, la détection du fait que le conducteur neutre (N) n'est pas relié à la borne de conducteur (6) destinée à la liaison avec le conducteur neutre (N) ayant lieu dans le cas contraire.

2. Procédé selon la revendication 1, **caractérisé en ce que**, pour la poursuite du fonctionnement de l'onduleur (1), une première conduite du fonctionnement adaptée à un fonctionnement à quatre conducteurs avec conducteur neutre (N) raccordé est sélectionnée lorsque, dans le cadre de l'étape de contrôle, il a été reconnu qu'une liaison du conducteur neutre (N) avec la borne de conducteur (6) destinée à la liaison avec le conducteur neutre (N) est présente, et **en ce que** dans le cas contraire, une deuxième conduite du fonctionnement, différente de la première conduite du fonctionnement, adaptée à un fonctionnement à trois conducteurs sans conducteur neutre (N) raccordé est sélectionnée.

3. Procédé selon la revendication 2, **caractérisé en ce qu'**il est prédéfini, à l'aide d'une valeur de référence mémorisée dans l'onduleur (1), si l'onduleur (1) doit fonctionner dans un mode d'injection au moyen de la première conduite du fonctionnement ou au moyen de la deuxième conduite du fonctionnement.

4. Procédé selon la revendication 3, **caractérisé en ce qu'**en cas de conflit entre la conduite du fonctionnement prédéfinie par la valeur de référence et la conduite du fonctionnement à sélectionner du fait de l'étape de contrôle, un message d'alerte est généré, lequel est mémorisé dans l'onduleur (1) et/ou communiqué à un opérateur de l'onduleur (1).

5. Procédé selon l'une des revendications 2 à 4, **caractérisé en ce que** l'onduleur (1) est mis en fonctionnement au moyen de la conduite du fonctionnement sélectionnée du fait de l'étape de contrôle.

6. Procédé selon l'une des revendications 3 à 5, **caractérisé en ce que** dans le cas d'un conflit entre la conduite du fonctionnement prédéfinie par la valeur de référence et la conduite du fonctionnement sélectionnée du fait de l'étape de contrôle, l'onduleur (1) n'injecte aucune puissance électrique dans le réseau de tension alternative (7).

7. Procédé selon la revendication 5, **caractérisé en ce que** l'onduleur (1) injecte de la puissance électrique dans le réseau de tension alternative (8).

8. Procédé selon la revendication 7, **caractérisé en ce que** la première conduite du fonctionnement comprend une injection asymétrique des courants de sortie (I_{L1}, I_{L2}, I_{L3}) dans le réseau de tension alternative (7).

9. Procédé selon l'une des revendications précédentes, **caractérisé en ce que** l'étape de contrôle est exécutée dans le cadre d'une mise en service et/ou pendant un processus de démarrage de l'onduleur (1).

10. Procédé selon l'une des revendications précédentes, **caractérisé en ce que** dans le cadre de l'étape de contrôle, les éléments de commutation du circuit en pont (8) de l'onduleur (1) sont commandés avec une fréquence supérieure à la fréquence du réseau en vue de générer un système homopolaire.

11. Procédé selon la revendication 10, **caractérisé en ce que** la fréquence du système homopolaire présente un multiple non entier de la fréquence du réseau.

12. Procédé selon l'une des revendications précédentes, **caractérisé en ce que** pour commander les éléments de commutation du circuit en pont (8) de l'onduleur (1) dans le cadre de l'étape de contrôle, une structure de régulation est utilisée, dans laquelle une valeur de consigne pour le courant du système homopolaire est comparée avec une valeur réelle du courant du système homopolaire.

13. Onduleur (1) destiné à convertir de la puissance électrique du courant continu en courant alternatif et à injecter la puissance électrique convertie dans un réseau de tension alternative (8), l'onduleur (1) possédant un raccordement (2) comprenant quatre bornes de conducteur (3-6) destinées à relier l'onduleur (1) à trois conducteurs externes (L1, L2, L3) et un conducteur neutre (N) d'un réseau de tension alternative (7),
**caractérisé en ce que** l'onduleur (1) comprend une unité de commande qui est conçue pour faire fonctionner l'onduleur (1) avec un procédé selon l'une des revendications précédentes.

14. Onduleur (1) selon la revendication 13, **caractérisé en ce que** la borne de conducteur (6) destinée au raccordement du conducteur neutre (N) est reliée à un point central (M) d'un circuit intermédiaire à tension continue (9).

15. Onduleur (1) selon l'une des revendications 13 et 14, **caractérisé en ce que** la borne de conducteur (6) destinée au raccordement du conducteur neutre (N) est reliée à une liaison entre deux éléments de commutation semiconducteurs, les éléments de commutation semiconducteurs formant un circuit série branché en parallèle d'un circuit intermédiaire à tension continue (9) .

16. Onduleur (1) selon l'une des revendications 14 et 15, **caractérisé en ce que** la borne de conducteur (6) destinée au raccordement du conducteur neutre (N) est reliée par le biais d'un élément de commutation (10) au point central (M) du circuit intermédiaire à tension continue (9) ou à la liaison entre les éléments de commutation semiconducteurs du circuit série branché en parallèle du circuit intermédiaire à tension continue (9) .
